# EUROPEAN PATENT APPLICATION

(11) **EP 4 766 094 A1**
(43) Date of publication of application: **24.06.2026**
(21) Application number: 25220617.2
(22) Date of filing: 04.12.2025
(51) Int. Cl.: H10D 89/60

(54) **BI-DIRECTIONAL ESD AND SURGE PROTECTION DEVICE**

(30) Priority: 18.12.2024 US 202463735793 P; 23.10.2025 US 202519366923
(71) Applicant: Semiconductor Components Industries, LLC, Scottsdale, AZ 85250 (US)
(72) Inventor: CHEN, Yupeng, San Jose, CA, 95148 (US); KEENA, Thomas, Chandler, AZ, 85225 (US); GILL, Chai Ean, Chandler, AZ, 85225 (US); ZHAN, Rouying, Chandler, AZ, 85248 (US)
(74) Representative: Manitz Finsterwald Patent- und Rechtsanwaltspartnerschaft mbB

(57) **Abstract**

An ESD protection device is disclosed. The ESD protection device comprises a first bipolar junction transistor including an emitter formed by a substrate having a first conductivity type, an open base formed by a first epitaxial region located above the substrate and having a second conductivity type, and a collector formed by a first well located in the first epitaxial region and having the first conductivity type. The ESD protection device also includes a second bipolar junction transistor having an emitter formed by the substrate, an open base formed by a second epitaxial region located above the substrate and having the second conductivity type, and a collector formed by a second well located in the second epitaxial region and having the first conductivity type. The ESD protection device further includes a trench including a dielectric material and located between the first and second epitaxial regions.

## Description

This application claims the benefit of provisional patent application No. 63/735,793, filed December 18, 2024, which is hereby incorporated by reference herein in its entirety.

### TECHNICAL FIELD

The disclosure relates generally to electrostatic discharge (ESD) protection devices, and specifically to high-voltage bi-directional ESD protection devices.

### BACKGROUND

In the electronics industry, manufacturers may use electrostatic discharge (ESD) devices to protect sensitive electronic components from damage by providing a safe path for excess electrical charge to dissipate to ground GND during an ESD event or other form of electrical surge. Such ESD devices may remain off during normal operation of the circuitry that they protect, but may activate during an ESD event to shunt excess current and to clamp the voltage at a safe level, thereby preventing damage to the protected circuitry.

In the automative industry, there is an industry trend for electrical systems of automobiles to be powered by 48 volt batteries as opposed to the traditional 12 volt batteries. The ESD devices in such high voltage systems must accordingly accommodate higher standoff voltages before activating. Inventors of embodiments of the present disclosure have recognized that the standoff voltage of an ESD device may be raised by increasing the thickness of an epitaxial region forming the ESD device, but that such an increased thickness may cause a corresponding increase in cost. Inventors of embodiments of the present disclosure have also recognized that deep trenches through such thick epitaxial regions may compromise the structural integrity of the device. Embodiments of the present disclosure may address one or more of these challenges.

### SUMMARY

The examples disclosed herein enable a high-voltage bi-directional ESD protection device that may be implemented with a high current density and a lower manufacturing cost for automative and industrial applications.

According to one embodiment, an ESD protection device comprises (i) a first bipolar junction transistor including an emitter formed by a substrate having a first conductivity type, an open base formed by a first epitaxial region located above the substrate and having a second conductivity type, and a collector formed by a first well located in the first epitaxial region and having the first conductivity type, (ii) a second bipolar junction transistor including an emitter formed by the substrate having the first conductivity type, an open base formed by a second epitaxial region located above the substrate and having the second conductivity type, and a collector formed by a second well located in the second epitaxial region and having the first conductivity type, and (iii) a trench including a dielectric material and located between the first epitaxial region and the second epitaxial region. In some embodiments, the first bipolar junction transistor and the second bipolar junction transistor are PNP bipolar junction transistors. In other embodiments, the first bipolar junction transistor and the second bipolar junction transistor are NPN bipolar junction transistors. In the same or different embodiments, the trench has a trench depth greater than an epitaxial depth of the first epitaxial region and the second epitaxial region. In the same or different embodiments, an epitaxial depth of the first epitaxial region and the second epitaxial region is less than 20 µm. In the same or different embodiments, an epitaxial depth of the first epitaxial region and the second epitaxial region is in a range between 4 and 20 µm. In the same or different embodiments, the ESD protection device is a bi-directional ESD protection device. In the same or different embodiments, the first epitaxial region and the second epitaxial region each include a first sublayer located above the substrate and having a first doping concentration, a second sublayer located above the first sublayer and having a second doping concentration greater than the first doping concentration, and a third sublayer located above the second sublayer and having a third doping concentration less than the second doping concentration. In the same or different embodiments, the second doping concentration of the second sublayer is greater than the first doping concentration of the first sublayer and the third doping concentration of the third sublayer by a factor of 10 or more.

According to another embodiment, an ESD protection device comprises (i) a first bipolar junction transistor and a second bipolar junction transistor coupled in series between a first terminal and a second terminal, (ii) the first bipolar junction transistor including an emitter formed by a substrate having a first conductivity type, an open base formed by a first epitaxial region located above the substrate and having a second conductivity type, and a collector formed by a first well located in the first epitaxial region and having the first conductivity type, the collector for the first bipolar junction transistor coupled to the first terminal, (iii) the second bipolar junction transistor including an emitter formed by the substrate having the first conductivity type, an open base formed by a second epitaxial region located above the substrate and having the second conductivity type, and a collector formed by a second well located in the second epitaxial region and having the first conductivity type, the collector of the second bipolar junction transistor coupled to the second terminal, and (iv) wherein a trench including a dielectric material is located between the first epitaxial region and the second epitaxial region. In some embodiments, the first bipolar junction transistor and the second bipolar junction transistor are PNP bipolar junction transistors. In other embodiments, the first bipolar junction transistor and the second bipolar junction transistor are NPN bipolar junction transistors. In the same or different embodiments, the trench has a trench depth greater than an epitaxial depth of the first epitaxial region and the second epitaxial region. In the same or different embodiments, an epitaxial depth of the first epitaxial region and the second epitaxial region is less than 20 µm. In the same or different embodiments, an epitaxial depth of the first epitaxial region and the second epitaxial region is in a range between 4 and 20 µm. In the same or different embodiments, the ESD protection device is a bi-directional ESD protection device. In the same or different embodiments, the first epitaxial region and the second epitaxial region each include a first sublayer located above the substrate and having a first doping concentration, a second sublayer located above the first sublayer and having a second doping concentration greater than the first doping concentration, and a third sublayer located above the second sublayer and having a third doping concentration less than the second doping concentration. In the same or different embodiments, the second doping concentration of the second sublayer is greater than the first doping concentration of the first sublayer and the third doping concentration of the third sublayer by a factor of 10 or more.

Another embodiment of the present disclosure includes a method for forming an ESD protection device, the method including providing a substrate having a first conductivity type to form an emitter of a first bipolar junction transistor and an emitter of a second bipolar junction transistor, forming an open base of the first bipolar junction transistor with a first epitaxial region having a second conductivity type, forming an open base of the second bipolar junction transistor with a second epitaxial region having the second conductivity type, forming a trench between the first epitaxial region and the second epitaxial region, forming a collector of the first bipolar junction transistor with a first well located in the first epitaxial region and having the first conductivity type, and forming a collector of the second bipolar junction transistor with a second well located in the second epitaxial region and having the first conductivity type. In some embodiments, the first epitaxial region and the second epitaxial region each are each formed with a first sublayer located above the substrate and having a first doping concentration, a second sublayer located above the first sublayer and having a second doping concentration greater than the first doping concentration, and a third sublayer located above the second sublayer and having a third doping concentration less than the second doping concentration. In the same or different embodiments, the second doping concentration of the second sublayer is greater than the first doping concentration of the first sublayer and the third doping concentration of the third sublayer by a factor of 10 or more. In some embodiments, the first bipolar junction transistor and the second bipolar junction transistor are formed as PNP bipolar junction transistors. In other embodiments, the first bipolar junction transistor and the second bipolar junction transistor are formed as NPN bipolar junction transistors. In the same or different embodiments, the trench is formed with a trench depth greater than an epitaxial depth of the first epitaxial region and the second epitaxial region. In the same or different embodiments, an epitaxial depth of the first epitaxial region and the second epitaxial region is less than 20 µm. In the same or different embodiments, an epitaxial depth of the first epitaxial region and the second epitaxial region is in a range between 4 and 20 µm. In the same or different embodiments, the ESD protection device is a bi-directional ESD protection device.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic view of an electronic system in accordance with embodiments of the present disclosure.
FIG. 2 illustrates a schematic view of an ESD protection device in accordance with embodiments of the present disclosure.
FIG. 3 illustrates a cross-sectional semiconductor layout view of an ESD protection device in accordance with embodiments of the present disclosure.
FIG. 4 illustrates a cross-sectional semiconductor layout view of an ESD protection device in accordance with embodiments of the present disclosure.
FIG. 5 illustrates a schematic view of an ESD protection device in accordance with embodiments of the present disclosure.
FIG. 6 illustrates a cross-sectional semiconductor layout view of an ESD protection device in accordance with embodiments of the present disclosure.
FIG. 7 illustrates a cross-sectional semiconductor layout view of an ESD protection device in accordance with embodiments of the present disclosure.
FIG. 8 illustrates a method for forming an ESD protection device in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to encompass either an indirect connection or a direct connection. Thus, if a first device couples to, or is coupled to, a second device, that connection between the first device and the second device may be through a direct connection or through an indirect connection via other devices and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

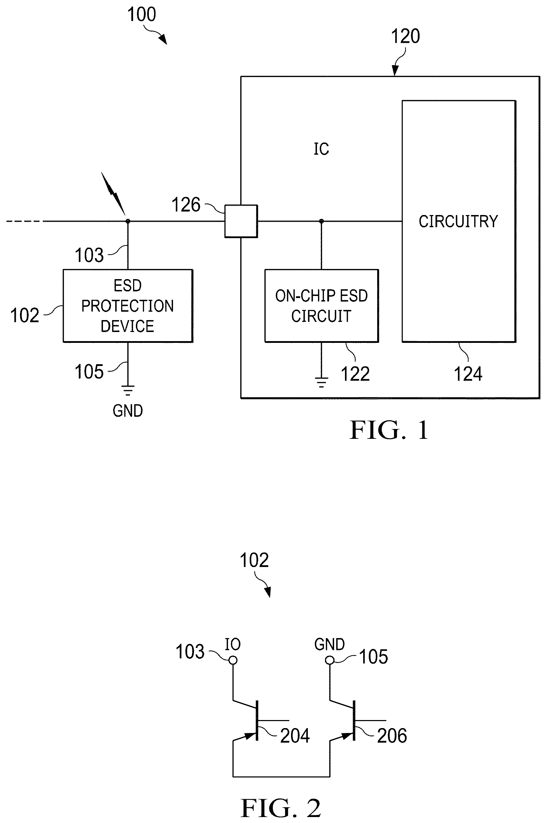

FIG. 1 illustrates a schematic view of electronic system 100 in accordance with embodiments of the present disclosure. Electronic system 100 may include ESD protection device 102 and integrated circuit 120. In some embodiments, integrated circuit 120 may be formed in its own integrated circuit package and affixed to a printed circuit board. Integrated circuit 120 may include internal circuitry 124, as well as an on-chip ESD circuit 122. In some embodiments, the on-chip ESD circuit 122 may protect internal circuitry 124 from various ESD events and/or electrical surges at input/output (IO) terminal 126. However, the protection provided by the on-chip ESD circuit 122 may be constrained due to the fact that the design of an on-chip ESD circuit 122 may utilize the same semiconductor process flow used by, and optimized for, internal circuitry 124. Accordingly, electronic system 100 may also utilize ESD protection device 102 external to integrated circuit 120.

As shown in FIG. 1, ESD protection device 102 may include a first terminal 103 and a second terminal 105. The first terminal 103 may be coupled to the input/output terminal 126 of integrated circuit 120. The second terminal 105 may be coupled to ground GND. Accordingly, ESD protection device 102 may provide additional ESD and/or surge protection for internal circuitry 124 of integrated circuit 120. As described in further detail below with reference to FIGS. 2-4, ESD protection device 102 may be a bi-directional ESD protection device. For example, ESD protection device 102 may have a reverse working maximum voltage (also referred to as a reverse stand-off voltage) of +/- 40 to 80 Vrwm.

ESD protection device 102 may be formed on a semiconductor die separate from that of integrated circuit 120. In some embodiments, ESD protection device 102 may be included within an integrated circuit package separate from the integrated circuit package of integrated circuit 120. In other embodiments, ESD protection device 102 may be co-packaged with integrated circuit 120 in a multi-die integrated circuit package.

FIG. 2 illustrates a schematic view of ESD protection device 102 in accordance with embodiments of the present disclosure. As shown in FIG. 2, ESD protection device 102 may include first bipolar junction transistor 204 and second bipolar junction transistor 206 coupled in series between first terminal 103 and second terminal 105. In some embodiments, first terminal 103 may be coupled to an input/output pin of a circuit to be protected, while second terminal 105 is coupled to ground GND. But as shown in FIG. 2, first bipolar junction transistor 204 and second bipolar junction transistor 206 may be coupled together in series in a symmetric manner. Accordingly, first terminal 103 and second terminal 105 may be interchangeable with each other. Further, the designation of first bipolar junction transistor 204 as "first," and second bipolar junction transistor 206 as "second," may also be interchangeable.

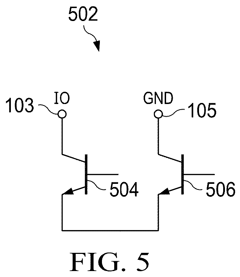

In some embodiments, and as shown in FIG. 2, first bipolar junction transistor 204 and second bipolar junction transistor 206 may be PNP bipolar junction transistors. In other embodiments described below with reference to FIGS. 5-7, the first bipolar junction transistor and the second bipolar junction transistor may alternatively be NPN bipolar junction transistors.

As shown in FIG. 2, first bipolar junction transistor 204 may include a collector coupled to first terminal 103. First bipolar junction transistor 204 may also include an open base. For example, the base of first bipolar junction transistor 204 may be left in an open circuit condition. Second bipolar junction transistor 206 may include a collector coupled to second terminal 105. Like first bipolar junction transistor 204, second bipolar junction transistor 206 may also include an open base. As also shown in FIG. 2, first bipolar junction transistor 204 may include an emitter coupled to the emitter of second bipolar junction transistor 206. Because first bipolar junction transistor 204 and second bipolar junction transistor 206 are coupled together in series in a symmetric manner, ESD protection device 102 may be a bi-directional ESD protection device able to provide surge protection for either positive or negative transients.

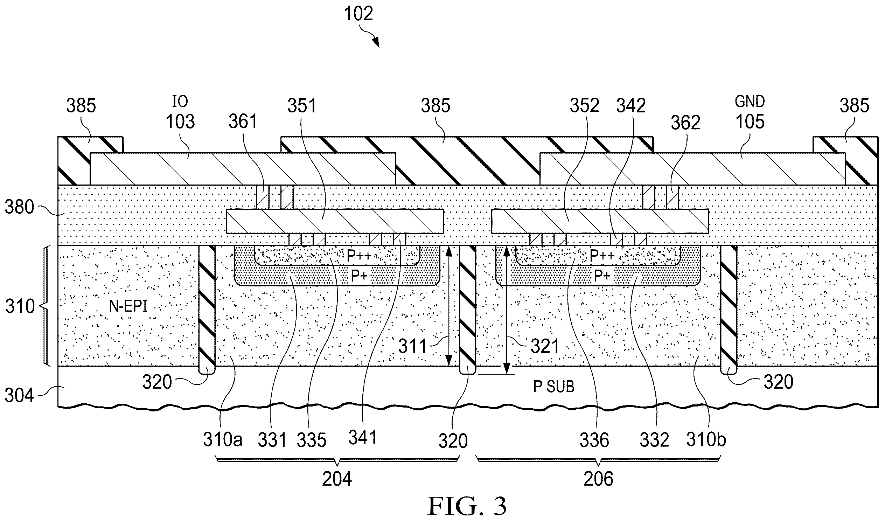

FIG. 3 illustrates a cross-sectional semiconductor layout view of ESD protection device 102 in accordance with embodiments of the present disclosure. As described in detail below, first bipolar junction transistor 204 and second bipolar junction transistor 206 of ESD protection device 102 may be collectively formed by substrate 304, epitaxial layer 310 (including first epitaxial region 310a and second epitaxial region 310b), trenches 320, first well 331, and second well 332.

In some embodiments, substrate 304 may have a first conductivity type. For example, in embodiments where first bipolar junction transistor 204 and second bipolar junction transistor 206 are PNP bipolar junction transistors, substrate 304 may be a p-type substrate. Epitaxial layer 310 may be located above substrate 304. In some embodiments, epitaxial layer 310 may have a second conductivity type. For example, in embodiments where first bipolar junction transistor 204 and second bipolar junction transistor 206 are PNP bipolar junction transistors, epitaxial layer 310 may be an n-type layer.

As shown in FIG. 3, epitaxial layer 310 may be divided into a first epitaxial region 310a and a second epitaxial region 310b by a trench 320. For example, ESD protection device 102 may include a trench 320 located between first epitaxial region 310a and second epitaxial region 310b. Further instances of trench 320, together with the instance of trench 320 between first epitaxial region 310a and second epitaxial region 310b, may enclose first epitaxial region 310a and second epitaxial region 310b from a horizontal perspective. In some embodiments, trench 320 may have a trench depth 321 greater than the epitaxial depth 311 of first epitaxial region 310a and second epitaxial region 310b. Trench 320 may include a dielectric material, such as silicon dioxide or any other dielectric material suitable to electrically insulate first epitaxial region 310a from second epitaxial region 310b. As described above for epitaxial layer 310, first epitaxial region 310a and second epitaxial region 310b may have the second conductivity type. For example, in embodiments where first bipolar junction transistor 204 and second bipolar junction transistor 206 are PNP bipolar junction transistors, first epitaxial region 310a and second epitaxial region 310b may be n-type regions.

First well 331 may be located in first epitaxial region 310a. Second well 332 may be located in second epitaxial region 310b. For example, first well 331 and second well 332 may be formed by a patterned doping process occurring prior to the formation of dielectric layer 380 and various routing structures above epitaxial layer 310. In some embodiments, first well 331 and second well 332 may have the first conductivity types. For example, in embodiments where first bipolar junction transistor 204 and second bipolar junction transistor 206 are PNP bipolar junction transistors, first well 331 and second well 332 may be p-type wells.

In some embodiments, first well 331 may include a first contact region 335. Similarly, second well 332 may include second contact region 336. First contact region 335 and second contact region 336 may have the same first conductivity type as first well 331 and second well 332. Further, first contact region 335 and second contact region 336 may have a greater doping concentration relative to first well 331 and second well 332, and thus help facilitate low-resistive couplings to above routing layers. In some embodiments, first contact region 335 and second contact region 336 may be formed by an additional patterned doping process occurring before or after the doping process forming first well 331 and second well 332, and prior to the formation of dielectric layer 380 and various routing structures above epitaxial layer 310.

As described above, first bipolar junction transistor 204 and the second bipolar junction transistor 206 may be collectively formed by substrate 304, epitaxial layer 310 (including first epitaxial region 310a and second epitaxial region 310b), trenches 320, first well 331, and second well 332. For example, first bipolar junction transistor 204 may include an emitter formed by substrate 304 having the first conductivity type, an open base formed by first epitaxial region 310a located above substrate 304 and having the second conductivity type, and a collector formed by the first well 331 located in first epitaxial region 310a and having the first conductivity type. Further, second bipolar junction transistor 206 may include an emitter formed by substrate 304 having the first conductivity type, an open base formed by second epitaxial region 310b located above substrate 304 and having the second conductivity type, and a collector formed by the second well 332 located in second epitaxial region 310b and having the first conductivity type.

As described above, the emitter of first bipolar junction transistor 204 and the emitter of second bipolar junction transistor 206 may both be formed by substrate 304. Accordingly, as also described above with reference to FIG. 2, the respective emitters of first bipolar junction transistor 204 and second bipolar junction transistor 206 may be coupled together.

Further, the collector of first bipolar junction transistor 204 (formed by first well 331) may be coupled to first terminal 103. Similarly, the collector of second bipolar junction transistor 206 (formed by second well 332) may be coupled to second terminal 105. For example, as shown in FIG. 3, a dielectric layer 380 may be disposed over the surface of epitaxial layer 310. Dielectric layer 380 may include, for example, silicon dioxide or any other dielectric material suitable to electrically insulate different routing structures formed therein. First terminal 103 and second terminal 105 may be formed by patterns of a second metal layer over dielectric layer 380. The second metal layer used to form first terminal 103 and/or second terminal 105 may include, for example, aluminum, copper, titanium, or any other suitable metal or metal alloy. First terminal 103 may be coupled through dielectric layer 380 to first well 331 (and first contact region 335) via a first set of contacts 341, a first-layer metal connection 351, and vias 361. Similarly, second terminal 105 may be coupled through dielectric layer 380 to second well 332 (and second contact region 336) via a second set of contacts 342, a first-layer metal connection 352, and vias 362. A surface dielectric 385 may be disposed above dielectric layer 380 as well as portions of first terminal 103 and second terminal 105. Surface dielectric 385 may include a dielectric material, such as silicon dioxide, or any other dielectric material suitable to electrically insulate the first terminal 103 and the second terminal 105 from each other. And as shown in FIG. 3, surface dielectric 385 may be patterned to expose portions of first terminal 103 and second terminal 105, such that first terminal 103 and second terminal 105 may be coupled to leads of an integrated circuit package, for example via bond wires or any other suitable coupling.

The breakdown voltage of ESD protection device 102 may depend in part on the doping concentration and thickness of epitaxial layer 310. By forming first bipolar junction transistor 204 and second bipolar junction transistor 206 separately from each other with the first epitaxial region 310a and second epitaxial region 310b, the breakdown voltage of ESD protection device 102 may benefit from two separate instances of the thickness of epitaxial layer 310. Accordingly, ESD protection device 102 may have a larger breakdown voltage for a given thickness (and cost) of epitaxial layer 310 relative to devices that utilize a single instance of the thickness of the epitaxial layer to support the breakdown voltage. In some embodiments, the epitaxial depth 311 of first epitaxial region 310a and second epitaxial region 310b may be less than 20 µm, for example, while still supporting a breakdown voltage up to +/- 80 Vrwm or more for high-voltage automotive and/or industrial applications. For example, the epitaxial depth may in some embodiments be in a range between 4 and 20 µm. In the same or other embodiments, the epitaxial depth may be in a range between 10 and 20 µm.

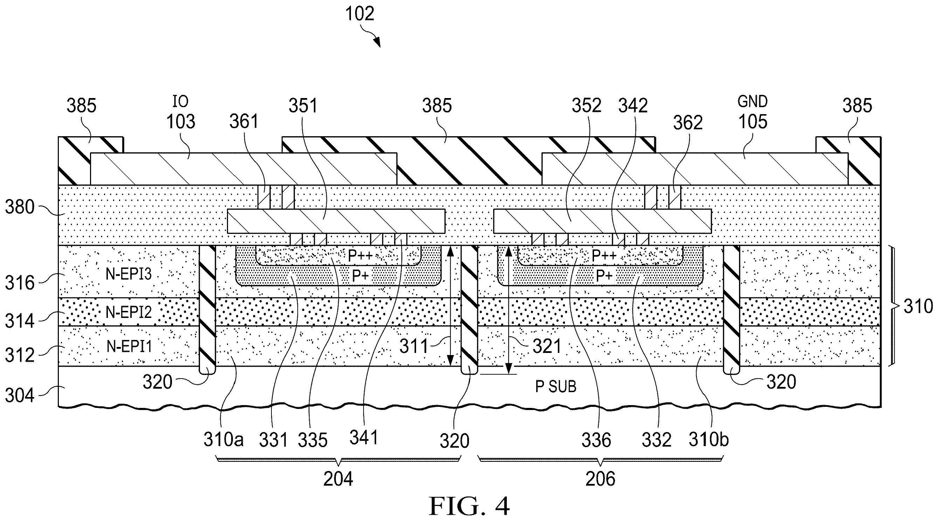

FIG. 4 illustrates a cross-sectional semiconductor layout view of ESD protection device 102 in accordance with embodiments of the present disclosure. Specifically, FIG. 4 illustrates an embodiment in which the epitaxial layer 310 (and thus first epitaxial region 310a and second epitaxial region 310b) of ESD protection device 102 includes first, second, and third sublayers.

As shown in FIG. 4, first epitaxial region 310a and second epitaxial region 310b may each include a first sublayer 312 located above substrate 304, a second sublayer 314 located above first sublayer 312, and third sublayer 316 located above second sublayer 314. First sublayer 312 may have a first doping concentration, second sublayer 314 may have a second doping concentration, and third sublayer 316 may have a third doping concentration.

In some embodiments, the second doping concentration of second sublayer 314 may be greater than the first doping concentration of first sublayer 312 and the third doping concentration of third sublayer 316 by a factor of 10 or more. In some embodiments, the third doping concentration of third sublayer 316 may be approximately equal to the first doping concentration of first sublayer 312. The lighter doping of first sublayer 312 and third sublayer 316 may help support a higher breakdown voltage for ESD protection device 102. Meanwhile, the greater doping concentration of second sublayer 314 may reduce the beta of first bipolar junction transistor 204 and second bipolar junction transistor 206, thereby improving the snapback performance of ESD protection device 102 as a whole.

FIG. 5 illustrates a schematic view of ESD protection device 502 in accordance with embodiments of the present disclosure. As shown in FIG. 5, ESD protection device 502 may include first bipolar junction transistor 504 and second bipolar junction transistor 506 coupled in series between first terminal 103 and second terminal 105. In some embodiments, first terminal 103 may be coupled to an input/output pin of a circuit to be protected, while second terminal 105 is coupled to ground GND. But as shown in FIG. 5, first bipolar junction transistor 504 and second bipolar junction transistor 506 may be coupled together in series in a symmetric manner. Accordingly, first terminal 103 and second terminal 105 may be interchangeable with each other. Further, the designation of first bipolar junction transistor 504 as "first," and second bipolar junction transistor 506 as "second," may also be interchangeable.

In some embodiments, and as shown in FIG. 5, first bipolar junction transistor 504 and second bipolar junction transistor 506 may be NPN bipolar junction transistors. First bipolar junction transistor 504 may include a collector coupled to first terminal 103. First bipolar junction transistor 504 may also include an open base. For example, the base of first bipolar junction transistor 504 may be left in an open circuit condition. Second bipolar junction transistor 506 may include a collector coupled to second terminal 105. Like first bipolar junction transistor 504, second bipolar junction transistor 506 may also include an open base. As also shown in FIG. 5, first bipolar junction transistor 504 may include an emitter coupled to the emitter of second bipolar junction transistor 506. Because first bipolar junction transistor 504 and second bipolar junction transistor 506 are coupled together in series in a symmetric manner, ESD protection device 502 may be a bi-directional ESD protection device able to provide surge protection for either positive or negative transients.

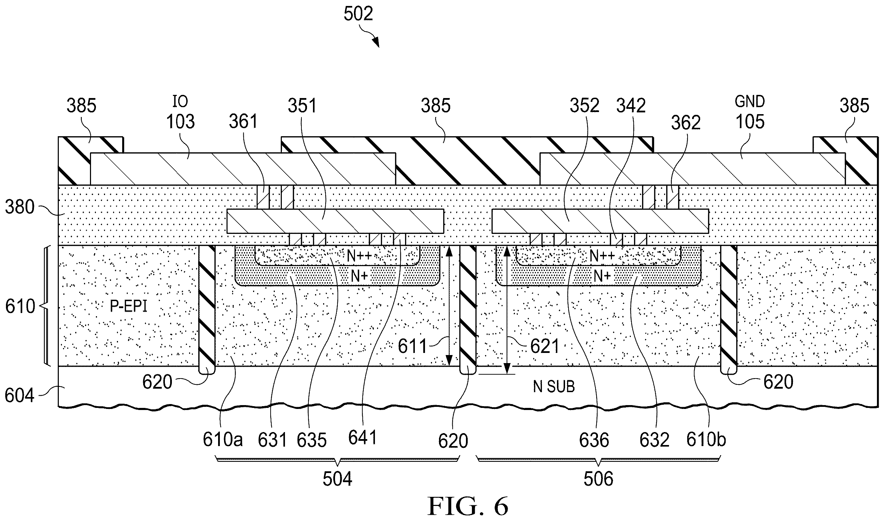

FIG. 6 illustrates a cross-sectional semiconductor layout view of ESD protection device 502 in accordance with embodiments of the present disclosure. As described in detail below, first bipolar junction transistor 504 and second bipolar junction transistor 506 of ESD protection device 502 may be collectively formed by substrate 604, epitaxial layer 610 (including first epitaxial region 610a and second epitaxial region 610b), trenches 620, first well 631, and second well 632.

In some embodiments, substrate 604 may have a first conductivity type. For example, in embodiments where first bipolar junction transistor 504 and second bipolar junction transistor 506 are NPN bipolar junction transistors, substrate 604 may be an n-type substrate. Epitaxial layer 610 may be located above substrate 604. In some embodiments, epitaxial layer 610 may have a second conductivity type. For example, in embodiments where first bipolar junction transistor 504 and second bipolar junction transistor 506 are NPN bipolar junction transistors, epitaxial layer 610 may be a p-type layer.

As shown in FIG. 6, epitaxial layer 610 may be divided into first epitaxial region 610a and second epitaxial region 610b by a trench 620. For example, ESD protection device 502 may include a trench 620 located between first epitaxial region 610a and second epitaxial region 610b. Further instances of trench 620, together with the instance of trench 620 between first epitaxial region 610a and second epitaxial region 610b, may enclose first epitaxial region 310a and second epitaxial region 310b from a horizontal perspective. In some embodiments, trench 620 may have a trench depth 621 greater than the epitaxial depth 611 of first epitaxial region 610a and second epitaxial region 610b. Trench 620 may include a dielectric material, such as silicon dioxide or any other dielectric material suitable to electrically insulate first epitaxial region 610a from second epitaxial region 610b. As described above for epitaxial layer 610, first epitaxial region 610a and second epitaxial region 610b may have the second conductivity type. For example, in embodiments where first bipolar junction transistor 504 and second bipolar junction transistor 506 are NPN bipolar junction transistors, first epitaxial region 610a and second epitaxial region 610b may be p-type regions.

First well 631 may be located in first epitaxial region 610a. Second well 632 may be located in second epitaxial region 610b. For example, first well 631 and second well 632 may be formed by a patterned doping process occurring prior to the formation of dielectric layer 380 and various routing structures above epitaxial layer 610. In some embodiments, first well 631 and second well 632 may have the first conductivity types. For example, in embodiments where first bipolar junction transistor 504 and second bipolar junction transistor 506 are NPN bipolar junction transistors, first well 631 and second well 632 may be n-type wells.

In some embodiments, first well 631 may include a first contact region 635. Similarly, second well 632 may include second contact region 636. First contact region 635 and second contact region 636 may have the same first conductivity type as first well 631 and second well 632. Further, first contact region 635 and second contact region 636 may have a greater doping concentration relative to first well 631 and second well 632, and may thus help facilitate low-resistive couplings to above routing layers. In some embodiments, first contact region 635 and second contact region 636 may be formed by an additional patterned doping process occurring before or after the doping process forming first well 631 and second well 632, and prior to the formation of dielectric layer 380 and various routing structures above epitaxial layer 610.

As described above, first bipolar junction transistor 504 and the second bipolar junction transistor 506 may be collectively formed by substrate 604, epitaxial layer 610 (including first epitaxial region 610a and second epitaxial region 610b), trenches 620, first well 631, and second well 632. For example, first bipolar junction transistor 504 may include an emitter formed by substrate 604 having the first conductivity type, an open base formed by first epitaxial region 610a located above substrate 604 and having the second conductivity type, and a collector formed by the first well 631 located in first epitaxial region 610a and having the first conductivity type. Further, second bipolar junction transistor 506 may include an emitter formed by substrate 604 having the first conductivity type, an open base formed by second epitaxial region 610b located above substrate 604 and having the second conductivity type, and a collector formed by the second well 632 located in second epitaxial region 610b and having the first conductivity type.

As described above, the emitter of first bipolar junction transistor 504 and the emitter of second bipolar junction transistor 506 may both be formed by substrate 604. Accordingly, as also described above with reference to FIG. 5, the respective emitters of first bipolar junction transistor 504 and second bipolar junction transistor 506 may be coupled together.

Further, the collector of first bipolar junction transistor 504 (formed by first well 631) may be coupled to first terminal 103. Similarly, the collector of second bipolar junction transistor 506 (formed by second well 632) may be coupled to second terminal 105. For example, as shown in FIG. 6, a dielectric layer 380 may be disposed over the surface of epitaxial layer 610. Dielectric layer 380 may include, for example, silicon dioxide or any other dielectric material suitable to electrically insulate different routing structures formed therein. First terminal 103 and second terminal 105 may be formed by patterns of a second metal layer over dielectric layer 380. The second metal layer used to form first terminal 103 and second terminal 105 may include, for example, aluminum, copper, titanium, or any other suitable metal or metal alloy. First terminal 103 may be coupled through dielectric layer 380 to first well 631 (and first contact region 635) via a first set of contacts 341, a first-layer metal connection 351, and vias 361. Similarly, second terminal 105 may be coupled through dielectric layer 380 to second well 632 (and second contact region 636) via a second set of contacts 342, a first-layer metal connection 352, and vias 362. A surface dielectric 385 may be disposed above dielectric layer 380 as well as portions of first terminal 103 and second terminal 105. Surface dielectric 385 may include a dielectric material, such as silicon dioxide, or any other dielectric material suitable to electrically insulate the first terminal 103 and the second terminal 105 from each other. And as shown in FIG. 6, surface dielectric 385 may be patterned to expose portions of first terminal 103 and second terminal 105, such that first terminal 103 and second terminal 105 may be coupled to leads of an integrated circuit package, for example via bond wires or any other suitable coupling.

The breakdown voltage of ESD protection device 502 may depend in part on the doping concentration and thickness of epitaxial layer 610. By forming first bipolar junction transistor 504 and second bipolar junction transistor 506 separately from each other with the first epitaxial region 610a and second epitaxial region 610b, the breakdown voltage of ESD protection device 502 may benefit from two separate instances of the thickness of epitaxial layer 610. Accordingly, ESD protection device 502 may have a larger breakdown voltage for a given thickness (and cost) of epitaxial layer 610 relative to devices that utilize a single instance of the thickness of the epitaxial layer to support the breakdown voltage. In some embodiments, the epitaxial depth 611 of first epitaxial region 610a and second epitaxial region 610b may be less than 20 µm, for example, while still supporting a breakdown voltage up to +/- 80 Vrwm or more for high-voltage automotive and/or industrial applications. For example, the epitaxial depth may in some embodiments be in a range between 4 and 20 µm. In the same or other embodiments, the epitaxial depth may be in a range between 10 and 20 µm.

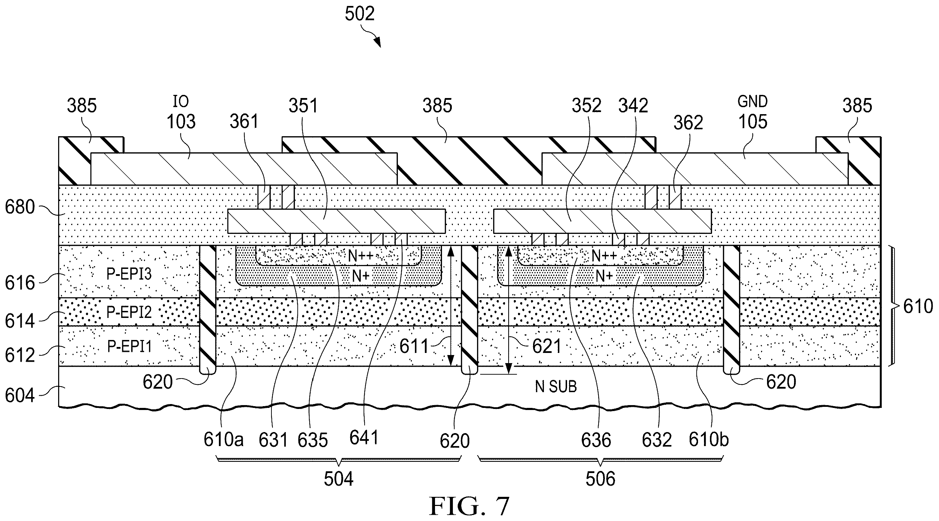

FIG. 7 illustrates a cross-sectional semiconductor layout view of ESD protection device 502 in accordance with embodiments of the present disclosure. Specifically, FIG. 7 illustrates an embodiment in which the epitaxial layer 610 (and thus first epitaxial region 610a and second epitaxial region 610b) of ESD protection device 502 includes first, second, and third sublayers.

As shown in FIG. 7, first epitaxial region 610a and second epitaxial region 610b may each include a first sublayer 612 located above substrate 604, a second sublayer 614 located above first sublayer 612, and third sublayer 616 located above second sublayer 614. First sublayer 612 may have a first doping concentration, second sublayer 614 may have a second doping concentration, and third sublayer 616 may have a third doping concentration.

In some embodiments, the second doping concentration of second sublayer 614 may be greater than the first doping concentration of first sublayer 612 and the third doping concentration of third sublayer 616 by a factor of 10 or more. In some embodiments, the third doping concentration of third sublayer 616 may be approximately equal to the first doping concentration of first sublayer 612. The lighter doping of first sublayer 612 and third sublayer 616 may help support a higher breakdown voltage for ESD protection device 502. Meanwhile, the greater doping concentration of second sublayer 614 may reduce the beta of first bipolar junction transistor 504 and second bipolar junction transistor 506, thereby improving the snapback performance of ESD protection device 502 as a whole.

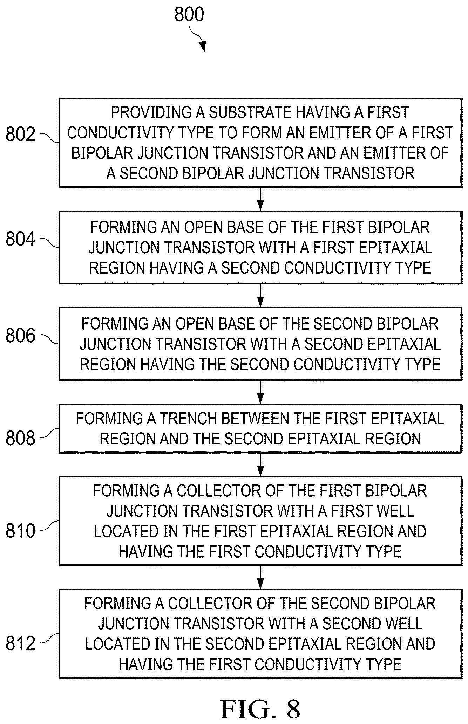

FIG. 8 illustrates a method 800 for forming an ESD protection device in accordance with embodiments of the present disclosure. In some embodiments, the steps of method 800 may be performed with fewer or more steps than shown in FIG. 8. For the sake of simplicity, additional semiconductor fabrication steps are omitted from the steps of method 800. For example, steps to form dielectric layers (such as dielectric layer 380 and surface dielectric 385) and the metal routing included within the dielectric layers, are omitted from the steps of method 800, but are understood to be part of a larger semiconductor process for manufacturing an ESD protection device. Moreover, in some embodiments, certain steps of method 800 may be omitted, repeated, performed in parallel, performed in a different order than shown in FIG. 8, or performed recursively. Moreover, one or more steps of method 800, although shown in an order, may be performed at the same time or in a re-ordered manner. As one example, steps 804 and 806 may be performed at the same time by the same semiconductor process steps. As another example, steps 810 and 812 may be performed at the same time by the same doping steps. Further, the trench formed in step 808 may be formed before or after the doping process used in steps 810 and 812.

Step 802 may include providing a substrate having a first conductivity type to form an emitter of a first bipolar junction transistor and an emitter of a second bipolar junction transistor. For example, as described above with reference to FIG. 3, a substrate 304 may be provided having the first conductivity type to form the emitter of first bipolar junction transistor 204 and the emitter of second bipolar junction transistor 206. In embodiments where first bipolar junction transistor 204 and second bipolar junction transistor 206 are PNP bipolar junction transistors, substrate 304 may be a p-type substrate.

Step 804 may include forming an open base of the first bipolar junction transistor with a first epitaxial region having a second conductivity type. For example, as described above with reference to FIG. 3, first epitaxial region 310a may form an open base for first bipolar junction transistor 204. First epitaxial region 310a may represent a region of epitaxial layer 310 which may be formed by epitaxial growth, for example, over substrate 304. In embodiments where first bipolar junction transistor 204 and second bipolar junction transistor 206 are PNP bipolar junction transistors, epitaxial layer 310 may be grown as an n-type epitaxial layer, and thus first epitaxial region 310a may be an n-type region.

Step 806 may include forming an open base of the second bipolar junction transistor with a second epitaxial region having the second conductivity type. For example, as described above with reference to FIG. 3, second epitaxial region 310b may form an open base for second bipolar junction transistor 206. Second epitaxial region 310b may represent a region of epitaxial layer 310 which may be formed by epitaxial growth, for example, over substrate 304. In embodiments where first bipolar junction transistor 204 and second bipolar junction transistor 206 are PNP bipolar junction transistors, epitaxial layer 310 may be grown as an n-type epitaxial layer, and thus second epitaxial region 310b may be an n-type region.

In some embodiments, the epitaxial depth of epitaxial layer 310 (and thus of first epitaxial region 310a and second epitaxial region 310b) may be in a range between 4 and 20 µm. As also described above with reference of FIG. 4, first epitaxial region 310a and second epitaxial region 310b may each include a first sublayer 312 located above substrate 304, a second sublayer 314 located above first sublayer 312, and third sublayer 316 located above second sublayer 314. In some embodiments, the various sublayers of epitaxial layer 310 may be grown, one at a time, with varied doping concentrations. For example, first sublayer 312 may have a first doping concentration, second sublayer 314 may have a second doping concentration greater than the first doping concentration, and third sublayer 316 may have a third doping concentration a third doping concentration less than the second doping concentration. In some embodiments, the second doping concentration of second sublayer 314 may be greater than the first doping concentration of first sublayer 312 and the third doping concentration of third sublayer 316 by a factor of 10 or more.

Step 808 may include forming a trench between the first epitaxial region and the second epitaxial region. For example, as described above with reference to FIG. 3, an instance of trench 320 may be formed between first epitaxial region 310a and second epitaxial region 310b. Trench 320 may be formed, for example, by an etch and fill process. For example, the space for trench 320 may first be etched into epitaxial layer 310. A dielectric material such as silicon dioxide may then be deposited to fill the etched space, thereby forming trench 320. In some embodiments, trench 320 may have a trench depth greater than the epitaxial depth of the first epitaxial region 310a and the second epitaxial region 310b.

Step 810 may include forming a collector of the first bipolar junction transistor with a first well located in the first epitaxial region and having the first conductivity type. For example, as described above with reference to FIG. 3, first well 331 may form the collector of first bipolar junction transistor 204. First well 331 may have the first conductivity type. For example, in embodiments where first bipolar junction transistor 204 and second bipolar junction transistor 206 are PNP bipolar junction transistors, first well 331 may be a p-type well. First well 331 may be formed for example, by doping a patterned area at the upper surface of first epitaxial region 310a.

Step 812 may include forming a collector of the second bipolar junction transistor with a second well located in the second epitaxial region and having the first conductivity type. For example, as described above with reference to FIG. 3, second well 332 may form the collector of second bipolar junction transistor 206. Second well 332 may have the first conductivity type. For example, in embodiments where first bipolar junction transistor 204 and second bipolar junction transistor 206 are PNP bipolar junction transistors, second well 332 may be a p-type well. Second well 332 may be formed for example, by doping a patterned area at the upper surface of second epitaxial region 310b.

Embodiments herein may include an ESD protection device. The ESD protection device may include a first bipolar junction transistor and a second bipolar junction transistor coupled in series between a first terminal and a second terminal. The first bipolar junction transistor may include an emitter formed by a substrate having a first conductivity type, an open base formed by a first epitaxial region located above the substrate and having a second conductivity type, and a collector formed by a first well located in the first epitaxial region and having the first conductivity type, wherein the collector for the first bipolar junction transistor is coupled to the first terminal. The second bipolar junction transistor may include an emitter formed by the substrate having the first conductivity type, an open base formed by a second epitaxial region located above the substrate and having the second conductivity type, and a collector formed by a second well located in the second epitaxial region and having the first conductivity type, wherein the collector of the second bipolar junction transistor is coupled to the second terminal. The ESD protection device may also include a trench that has a dielectric material and is located between the first epitaxial region and the second epitaxial region. The ESD protection device may have one or more of the following additional elements in any combination. Element 1: wherein the first bipolar junction transistor and the second bipolar junction transistor are PNP bipolar junction transistors. Element 2: wherein the first bipolar junction transistor and the second bipolar junction transistor are NPN bipolar junction transistors. Element 3: wherein the trench has a trench depth greater than an epitaxial depth of the first epitaxial region and the second epitaxial region. Element 4: wherein an epitaxial depth of the first epitaxial region and the second epitaxial region is less than 20 µm. Element 5: wherein an epitaxial depth of the first epitaxial region and the second epitaxial region is in a range between 4 and 20 µm. Element 6: wherein the ESD protection device is a bi-directional ESD protection device. Element 7: wherein the first epitaxial region and the second epitaxial region each include a first sublayer located above the substrate and having a first doping concentration, a second sublayer located above the first sublayer and having a second doping concentration greater than the first doping concentration, and a third sublayer located above the second sublayer and having a third doping concentration less than the second doping concentration. Element 8: wherein the second doping concentration of the second sublayer is greater than the first doping concentration of the first sublayer and the third doping concentration of the third sublayer by a factor of 10 or more.

Although examples have been described above, other modifications and variations may be made from this disclosure without departing from the spirit and scope of the examples that are described herein. The above descriptions of various embodiments illustrate the principles of the invention. Numerous variations and modifications will become apparent to those skilled in the art based on the above disclosure. The following claims are intended to embrace all such variations and modifications.

## Claims

1. An ESD protection device comprising:
a first bipolar junction transistor including:
an emitter formed by a substrate having a first conductivity type;
an open base formed by a first epitaxial region located above the substrate and having a second conductivity type; and
a collector formed by a first well located in the first epitaxial region and having the first conductivity type;
a second bipolar junction transistor including:
an emitter formed by the substrate having the first conductivity type;
an open base formed by a second epitaxial region located above the substrate and having the second conductivity type; and
a collector formed by a second well located in the second epitaxial region and having the first conductivity type; and
a trench including a dielectric material and located between the first epitaxial region and the second epitaxial region.

2. The ESD protection device of claim 1, wherein the first bipolar junction transistor and the second bipolar junction transistor are PNP bipolar junction transistors.

3. The ESD protection device of claim 1, wherein the first bipolar junction transistor and the second bipolar junction transistor are NPN bipolar junction transistors.

4. The ESD protection device of claim 1, wherein the trench has a trench depth greater than an epitaxial depth of the first epitaxial region and the second epitaxial region.

5. The ESD protection device of claim 1, wherein the ESD protection device is a bi-directional ESD protection device.

6. The ESD protection device of claim 1, wherein the first epitaxial region and the second epitaxial region each include:
a first sublayer located above the substrate and having a first doping concentration;
a second sublayer located above the first sublayer and having a second doping concentration greater than the first doping concentration; and
a third sublayer located above the second sublayer and having a third doping concentration less than the second doping concentration.

7. The ESD protection device of claim 6, wherein the second doping concentration of the second sublayer is greater than the first doping concentration of the first sublayer and the third doping concentration of the third sublayer by a factor of 10 or more.

8. An ESD protection device comprising:
a first bipolar junction transistor and a second bipolar junction transistor coupled in series between a first terminal and a second terminal;
the first bipolar junction transistor including:
an emitter formed by a substrate having a first conductivity type;
an open base formed by a first epitaxial region located above the substrate and having a second conductivity type; and
a collector formed by a first well located in the first epitaxial region and having the first conductivity type, the collector for the first bipolar junction transistor coupled to the first terminal;
the second bipolar junction transistor including:
an emitter formed by the substrate having the first conductivity type;
an open base formed by a second epitaxial region located above the substrate and having the second conductivity type; and
a collector formed by a second well located in the second epitaxial region and having the first conductivity type, the collector of the second bipolar junction transistor coupled to the second terminal; and
a trench including a dielectric material and located between the first epitaxial region and the second epitaxial region.

9. A method for forming an ESD protection device, comprising:
providing a substrate having a first conductivity type to form an emitter of a first bipolar junction transistor and an emitter of a second bipolar junction transistor;
forming an open base of the first bipolar junction transistor with a first epitaxial region having a second conductivity type;
forming an open base of the second bipolar junction transistor with a second epitaxial region having the second conductivity type;
forming a trench between the first epitaxial region and the second epitaxial region;
forming a collector of the first bipolar junction transistor with a first well located in the first epitaxial region and having the first conductivity type; and
forming a collector of the second bipolar junction transistor with a second well located in the second epitaxial region and having the first conductivity type.

10. The method of claim 9, wherein the first epitaxial region and the second epitaxial region are each formed with:
a first sublayer located above the substrate and having a first doping concentration;
a second sublayer located above the first sublayer and having a second doping concentration greater than the first doping concentration; and
a third sublayer located above the second sublayer and having a third doping concentration less than the second doping concentration.

11. The method of claim 10, wherein the second doping concentration of the second sublayer is greater than the first doping concentration of the first sublayer and the third doping concentration of the third sublayer by a factor of 10 or more.

12. The method of claim 9, wherein the trench is formed with a trench depth greater than an epitaxial depth of the first epitaxial region and the second epitaxial region.

13. The method of claim 9, wherein the first bipolar junction transistor and the second bipolar junction transistor are PNP bipolar junction transistors.

14. The method of claim 9, wherein the first bipolar junction transistor and the second bipolar junction transistor are NPN bipolar junction transistors.

15. The method of claim 9, wherein the ESD protection device is a bi-directional ESD protection device.
